(19) Europäisches Patentamt
European Patent Office
Office européen des brevets

(11) **EP 3 100 353 B1**

(12) **EUROPEAN PATENT SPECIFICATION**

(45) Date of publication and mention
of the grant of the patent:
**09.03.2022 Bulletin 2022/10**

(21) Application number: **14702793.2**

(22) Date of filing: **30.01.2014**

(51) International Patent Classification (IPC):
*H03G 7/00* *(2006.01)*    *H03G 9/18* *(2006.01)*

(52) Cooperative Patent Classification (CPC):
**H03G 9/18; H03G 7/002; H03G 7/007**

(86) International application number:
**PCT/EP2014/051794**

(87) International publication number:
**WO 2015/113601 (06.08.2015 Gazette 2015/31)**

(54) **AN AUDIO COMPRESSION SYSTEM FOR COMPRESSING AN AUDIO SIGNAL**

TONKOMPRESSIONSSYSTEM ZUR KOMPRIMIERUNG EINES TONSIGNALS

SYSTÈME DE COMPRESSION AUDIO POUR COMPRESSER UN SIGNAL AUDIO

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**07.12.2016 Bulletin 2016/49**

(73) Proprietor: **Huawei Technologies Co., Ltd.
Longgang District
Shenzhen, Guangdong 518129 (CN)**

(72) Inventors:
• **GROSCHE, Peter**
**80992 Munich (DE)**
• **LANG, Yue**
**80992 Munich (DE)**
• **ZHANG, Qing**
**80992 Munich (DE)**

(74) Representative: **Gill Jennings & Every LLP
The Broadgate Tower
20 Primrose Street
London EC2A 2ES (GB)**

(56) References cited:
EP-A2- 0 596 663       EP-A2- 2 637 422
WO-A1-2006/047600    WO-A1-2011/141772
JP-A- H07 122 953       US-A1- 2009 116 664
US-A1- 2010 318 353    US-B1- 7 848 531

**Description**

**TECHNICAL FIELD**

The invention relates to the field of audio signal processing.

**BACKGROUND**

The reduction of the dynamic range of an audio signal is an important topic in the fields of sound recording, sound reproduction and broadcasting. The reduction of the dynamic range can be relevant for adapting the characteristics of the audio signal on the physical capabilities of the employed audio equipment.

For reducing the dynamic range of an audio signal, compressors can be employed. The compression characteristic of a compressor can be controlled by a plurality of compression parameters which can significantly influence the perceived quality of the audio signal.

The adjustment of the parameters can be challenging due to the complex characteristics of human sound perception and largely depends on the properties of the audio signal.

In G. W. McNally, "Dynamic Range Control of Digital Audio Signals", Journal of the Audio Engineering Society, vol. 32, pp. 316-327, 1984, dynamic range compression using compressors is described.

US 2009/116664 A1 describes compressing the level of an audio signal by receiving an input audio signal, determining a measure of loudness of the signal using a perceptually derived filter, determining a target gain amount, determining a current gain amount using piecewise linear attack/release logic, and producing an output audio signal by adjusting the input audio signal by the current gain amount. An audio compression filter for compressing the level of audio can comprise a loudness measuring module configured to determine a measure of loudness using a perceptually derived filter, and a compression module configured to determine a target gain amount, determine a current gain amount using piecewise linear attack/release logic, and adjust an input audio signal by the current gain amount. Audio level compression can be implemented using integer calculations.

Further audio compression systems are known from WO 2011/141772 A1 and WO 2006/047600 A1.

**SUMMARY**

It is the object of the invention to provide an audio compression system for efficiently compressing an input audio signal which allows for a high perceived quality of the compressed audio signal.

This object is achieved by the features of the independent claims. Further implementation forms are apparent from the dependent claims, the description and the figures.

The invention is based on the finding that an input audio signal can be filtered by a digital filter, wherein a magnitude over frequency of a frequency transfer function of the digital filter can be formed by an equal loudness curve of a human ear. By filtering the input audio signal by the digital filter, portions of the input audio signal with low loudness sensitivity of the human ear can be amplified and portions of the input audio signal with high loudness sensitivity of the human ear can be attenuated. In other words, characteristics of human sound perception are considered for the audio signal processing according to the invention. A compressor can successively compress the input audio signal upon the basis of the filtered audio signal to obtain a compressed audio signal. The compression can therefore concentrate on portions of the input audio signal with low loudness sensitivity of the human ear and therefore enhance the perceived quality of the compressed audio signal.

According to a first aspect, the invention relates to an audio compression system as recited in claim 1, with which a high perceived quality of the compressed audio signal can be achieved.

The input audio signal can be a sampled and/or quantized audio signal. The input audio signal can comprise a mono audio signal, a stereo audio signal, or a multi-channel audio signal.

The digital filter can be implemented as a finite impulse response (FIR) filter or an infinite impulse response (IIR) filter. The filtering characteristic of the digital filter can be determined in frequency domain using the frequency transfer function.

The equal loudness curve of the human ear can relate to a sound pressure curve over frequency for which a human perceives a constant loudness using pure and/or steady tones. The equal loudness curve of the human ear can be an equal loudness curve according to ISO 226:2003.

The filtered audio signal can be a sampled and/or quantized audio signal. The filtered audio signal can comprise a mono audio signal, a stereo audio signal, or a multi-channel audio signal.

The compressor can be a digital compressor. The compressor can be configured to combine the input audio signal with the filtered audio signal to obtain the compressed audio signal.

The compressed audio signal can be a sampled and/or quantized audio signal. The compressed audio signal can comprise a mono audio signal, a stereo audio signal, or a multi-channel audio signal.

In a first implementation form of the audio compression system according to the first aspect as such, the digital filter is a time domain filter for time domain filtering a time domain input audio signal to provide a filtered audio signal in time domain. Thus, a low latency of filtering the input audio signal can be achieved.

The time domain input audio signal can be sampled to obtain a sequence of samples which can be filtered by the time domain filter to obtain a sequence of samples of the filtered audio signal. The time domain filter can be implemented e.g. using a direct form structure or a lattice structure.

In a second implementation form of the audio compression system according to the first aspect as such or any preceding implementation form of the first aspect, the frequency transfer function has a constant magnitude below or above a predetermined frequency. Thus, an overall range of the magnitudes of the frequency transfer function can be limited.

In case of a constant magnitude below a predetermined frequency, the predetermined frequency can e.g. be 10 Hz. In case of a constant magnitude above a predetermined frequency, the predetermined frequency can e.g. be 7 kHz.

The magnitudes of the frequency transfer function can be normalized over frequency. The mean value of the magnitudes of the frequency transfer function over frequency can have a value of one.

In a third implementation form of the audio compression system according to the first aspect as such or any preceding implementation form of the first aspect, a phase of the frequency transfer function increases or decreases linearly over frequency. Thus, a constant group delay of the digital filter can be achieved.

In a fourth implementation form of the audio compression system according to the first aspect as such, the first implementation form of the first aspect, or the second implementation form of the first aspect, a phase of the frequency transfer function is constant, in particular equal to zero, over frequency. Thus, the digital filter can be implemented efficiently.

The determining unit can be configured to determine the filter coefficients upon the basis of at least one equal loudness curve using a digital filter design technique, e.g. a Parks-McClellan algorithm. The filter coefficients can be real numbers, e.g. 2.5 or 7.8, or complex numbers, e.g. 1+j or 4-3j. The filter coefficients can comprise filter taps.

The filtering unit can comprise a finite impulse response (FIR) or an infinite impulse response (IIR) filter structure.

In a fifth implementation form of the audio compression system according to the first aspect, the determining unit is configured to select filter coefficients associated with the equal loudness curve from a set of filter coefficients associated with different equal loudness curves in order to determine the filter coefficients. Thus, different equal loudness curves can be employed by the digital filter.

In a sixth implementation form of the audio compression system according to the fifth implementation form of the first aspect, the different equal loudness curves are associated with different loudness levels of the audio signal, wherein the determining unit is further configured to determine the loudness level of the audio signal, and wherein the determining unit is further configured to select the filter coefficients associated with the equal loudness curve upon the basis of the determined loudness level. Thus, the frequency transfer function of the digital filter can be adapted according to the loudness level of the audio signal.

The loudness level of the audio signal can relate to a mean energy of the audio signal within a predetermined time interval. The predetermined time interval can e.g. be 20 ms or 100 ms.

In an seventh implementation form of the audio compression system according to the first aspect as such or any preceding implementation form of the first aspect, the compressor is configured to determine a compression gain signal upon the basis of the filtered audio signal, and to combine the input audio signal with the compression gain signal to obtain the compressed audio signal. Thus, the compression of the input audio signal can be performed efficiently.

The compression gain signal can be derived from the filtered audio signal upon the basis of a compression characteristic curve, e.g. a piecewise linear compression characteristic curve. The combination of the input audio signal with the compression gain signal can comprise a multiplication of the input audio signal with the compression gain signal.

In a eighth implementation form of the audio compression system according to the first aspect as such or any preceding implementation form of the first aspect, the audio compression system further comprises an equalization filter for filtering the compressed audio signal, the equalization filter comprising a frequency transfer function having a magnitude over frequency, the magnitude being formed by an equal loudness curve of a human ear. Thus, a flat frequency response of the audio compression system can be achieved.

The equal loudness curve of the human ear can relate to a sound pressure curve over frequency for which a human perceives a constant loudness using pure and/or steady tones. The equal loudness curve of the human ear can be an equal loudness curve according to ISO 226:2003.

In a ninth implementation form of the audio compression system according to the first aspect as such or any preceding implementation form of the first aspect, the audio compression system further comprises a peak limiter for reducing a maximum magnitude of the compressed audio signal in time domain. Thus, clipping effects of the compressed audio signal can be mitigated.

The peak limiter can be realized as a dynamic range compressor with a high compression threshold and/or a high compression ratio.

According to a second aspect, the invention relates to an audio compression method for compressing an input audio signal as recited in claim 11, by which a high perceived quality of the compressed audio signal can be achieved.

The audio compression method can be performed by the audio compression system according to the first aspect as such or any implementation form of the first aspect. Further features of the audio compression method can directly result from the functionality of the audio compression system according to the first aspect as such or any implementation form of the first aspect.

The equal loudness curve of the human ear can relate to a sound pressure curve over frequency for which a human perceives a constant loudness using pure and/or steady tones. The equal loudness curve of the human ear can be an equal loudness curve according to ISO 226:2003.

According to a third aspect, the invention relates to a computer program comprising a program code for performing the audio compression method according to the second aspect as such when executed on a computer. Thus, the method can be applied in an automatic and repeatable manner.

The computer program can be provided in form of a machine-readable program code. The program code can comprise a series of commands for a processor of the computer. The processor of the computer can be configured to execute the program code.

The invention can be implemented in hardware and/or software.

## BRIEF DESCRIPTION OF DRAWINGS

Implementations will be described with respect to the following figures, in which:

Fig. 1 shows a diagram of an audio compression system for compressing an input audio signal according to an implementation form;
Fig. 2 shows a diagram of an audio compression method for compressing an input audio signal according to an implementation form;
Fig. 3 shows a diagram of a digital filter for filtering an audio signal according to an implementation form;
Fig. 4 shows a diagram of a digital filtering method for filtering an audio signal according to an implementation form;
Fig. 5 shows a diagram of a high dynamic range audio signal and a compressed audio signal according to an implementation form;
Fig. 6 shows a diagram of a dynamic range compression principle according to an implementation form;
Fig. 7 shows a diagram of temporal smoothing using exponential decays according to an implementation form;
Fig. 8 shows a diagram of an audio compression system for compressing an input audio signal according to an implementation form;
Fig. 9 shows a diagram of different equal loudness curves according to an implementation form;
Fig. 10 shows a diagram of a digital filter for filtering an audio signal according to an implementation form;
Fig. 11 shows a diagram of a frequency response of a digital filter used to model the loudness sensitivity of the human ear according to an implementation form;
Fig. 12 shows a diagram of a compressor for compressing an input audio signal according to an implementation form;
Fig. 13 shows a diagram of a frequency response of an equalization filter according to an implementation form;
Fig. 14 shows a diagram illustrating an effect of the audio compression system on an input audio signal according to an implementation form;
Fig. 15 shows a diagram of an audio compression system for compressing an input audio signal according to an implementation form;
Fig. 16 shows a diagram of a compressor for compressing an input audio signal according to an implementation form; and
Fig. 17 shows a diagram of a digital filter for filtering an audio signal according to an implementation form.

Same reference signs refer to the same or equivalent features.

DETAILED DESCRIPTION

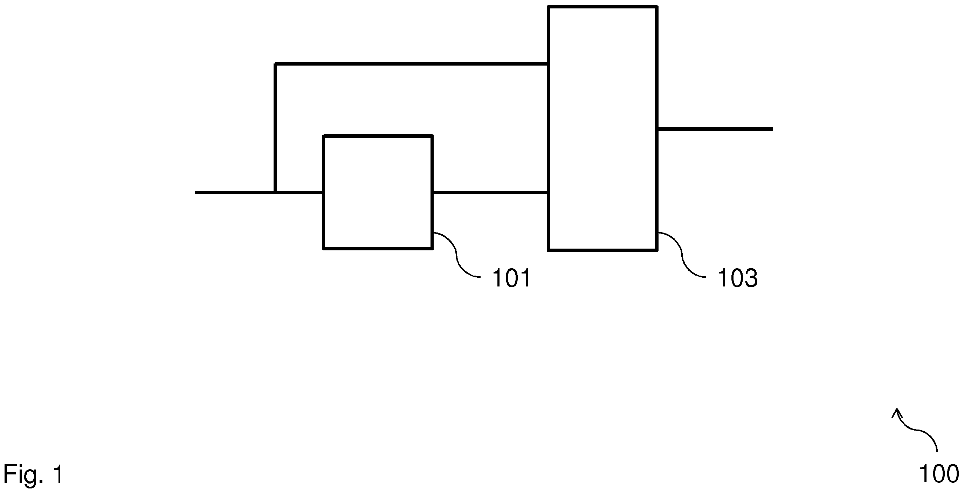

Fig. 1 shows a diagram of an audio compression system 100 for compressing an input audio signal according to an implementation form.

The audio compression system 100 comprises a digital filter 101 for filtering the input audio signal, the digital filter 101 comprising a frequency transfer function having a magnitude over frequency, the magnitude being formed by an equal loudness curve of a human ear to obtain a filtered audio signal, and a compressor 103 being configured to compress the input audio signal upon the basis of the filtered audio signal to obtain a compressed audio signal.

The input audio signal can be a sampled and/or quantized audio signal. The input audio signal can comprise a mono audio signal, a stereo audio signal, or a multi-channel audio signal.

The digital filter 101 can be implemented as a finite impulse response (FIR) filter or an infinite impulse response (IIR) filter. The filtering characteristic of the digital filter 101 can be determined in frequency domain using the frequency transfer function.

The equal loudness curve of the human ear can relate to a sound pressure curve over frequency for which a human perceives a constant loudness using pure and/or steady tones. The equal loudness curve of the human ear can be an equal loudness curve according to ISO 226:2003.

The filtered audio signal can be a sampled and/or quantized audio signal. The filtered audio signal can comprise a mono audio signal, a stereo audio signal, or a multi-channel audio signal.

The compressor 103 can be a digital compressor. The compressor 103 can be configured to combine the input audio signal with the filtered audio signal to obtain the compressed audio signal.

The compressed audio signal can be a sampled and/or quantized audio signal. The compressed audio signal can comprise a mono audio signal, a stereo audio signal, or a multi-channel audio signal.

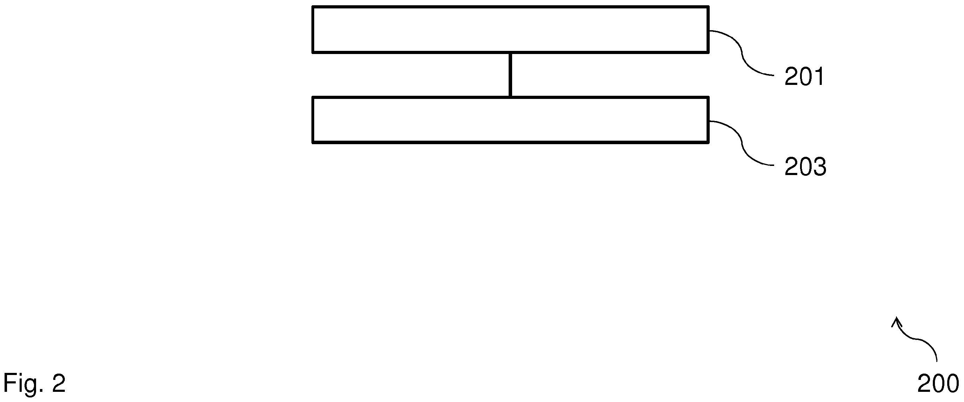

Fig. 2 shows a diagram of an audio compression method 200 for compressing an input audio signal according to an implementation form.

The audio compression method 200 comprises filtering 201 the input audio signal by a digital filter, the digital filter comprising a frequency transfer function having a magnitude over frequency, the magnitude being formed by an equal loudness curve of a human ear to obtain a filtered audio signal, and compressing 203 the input audio signal upon the basis of the filtered audio signal to obtain a compressed audio signal.

The audio compression method 200 can be performed by the audio compression system 100 of Fig. 1. Further features of the audio compression method 200 can directly result from the functionality of the audio compression system 100 of Fig. 1.

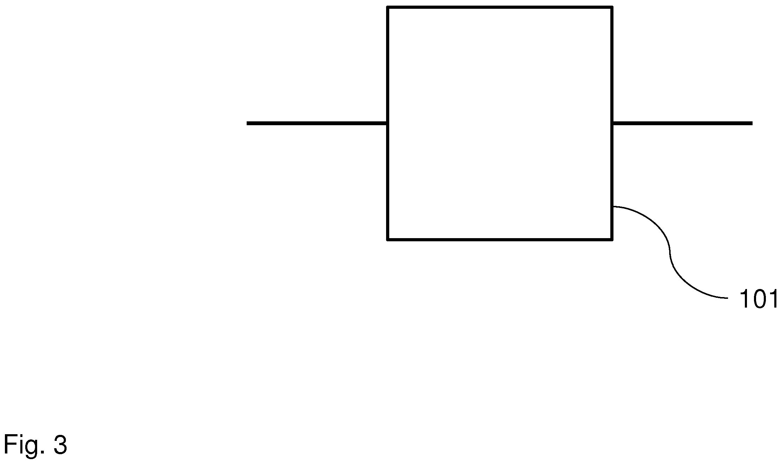

Fig. 3 shows a diagram of a digital filter 101 for filtering an audio signal according to an implementation form.

The digital filter 101 comprises a frequency transfer function having a magnitude over frequency, the magnitude being formed by an equal loudness curve of a human ear.

The equal loudness curve of the human ear can relate to a sound pressure curve over frequency for which a human perceives a constant loudness using pure and/or steady tones. The equal loudness curve of the human ear can be an equal loudness curve according to ISO 226:2003.

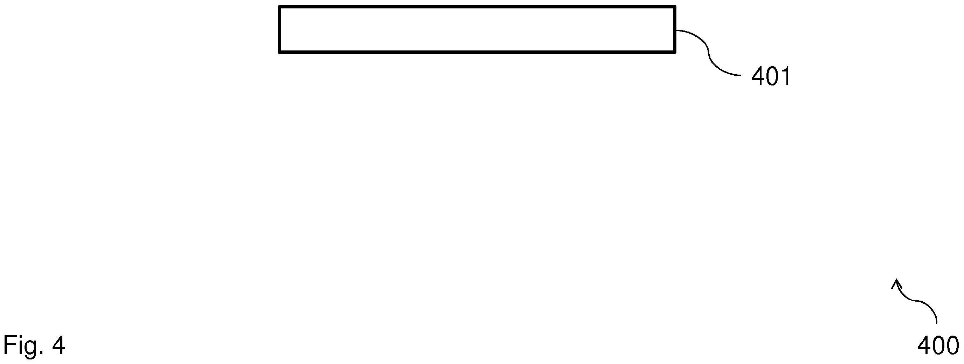

Fig. 4 shows a diagram of a digital filtering method 400 for filtering an audio signal according to an implementation form.

The digital filtering method 400 comprises filtering 401 the audio signal by a digital filter, the digital filter comprising a frequency transfer function having a magnitude over frequency, the magnitude being formed by an equal loudness curve of a human ear.

The digital filtering method 400 can be performed by the digital filter 101 of Fig. 3. Further features of the digital filtering method 400 can directly result from the functionality of the digital filter 101 of Fig. 3.

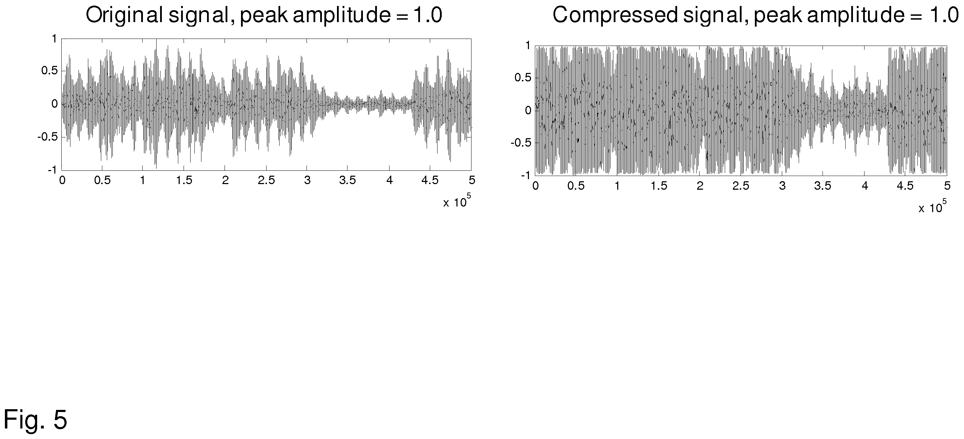

Fig. 5 shows a diagram of a high dynamic range audio signal and a compressed audio signal according to an implementation form. At the left, the original high dynamic range audio signal with peak amplitude of 1 is depicted. At the right, the compressed audio signal with peak amplitude of 1, but reduced dynamic range, is depicted.

Mobile devices such as tablets or smartphones are typically equipped with small, low quality micro-speakers and low-power amplifiers. As a result, the quality of the sound which can be reproduced by the electro-acoustic system in such devices can be limited. In particular, the maximum sound pressure level which can be produced can be limited. This can result in signal distortions at higher levels and a limited dynamic range.

Furthermore, such devices are often used to play sound in noisy environments which can demand for high output levels. Even more, further processing, such as stereo widening in order to compensate for the small distance between the speakers can reduce the maximum output level even further.

One solution to this problem can be an integration of speakers of higher quality and amplifiers with higher output power. However, this can demand for larger speakers which may not be integrated into small mobile devices and amplifiers consuming more energy from the battery. Therefore, there may be a demand for signal processing techniques which are able to enhance the perceived loudness of the acoustic signals produced by such mobile devices. Dynamic range compression (DRC) of audio signals can be one technique for loudness enhancement. The goal of DRC can be to increase the mean signal energy while keeping the peak energy within the limits imposed by the capabilities of the electro-acoustic system. To achieve this effect, one strategy can be to enhance the level of weak signal components.

The effect of a dynamic range compression of an audio signal is illustrated in Fig. 5. The left diagram shows signal amplitudes of a typical music example. The regularly occurring high amplitude peaks typically correspond to drum hits. The signal can be normalized to obtain a peak amplitude of 1 which may correspond to the maximum amplitude which can be handled by the electro-acoustic system. The amplitudes of digital audio signals are typically constraint to the interval [-1;1]. Amplitudes exceeding these limits can result in clipping, i.e. they can be limited to the limits. This can cause high signal distortion. This peak amplitude can restrict the overall output level of the signal as it can occur only rarely in the high dynamic range audio signal. Most parts of the signal can have low amplitude. The result of a dynamic range compression operation performed on this signal can result in the amplitude plot on the right of Fig. 5. While the peak amplitude of the resulting signal can still be 1, the mean amplitude which can define the perceived average loudness can be much higher. In particular, components with low amplitude can be significantly enhanced. The dynamic range which can be defined as the ratio of low to high energy components can be reduced.

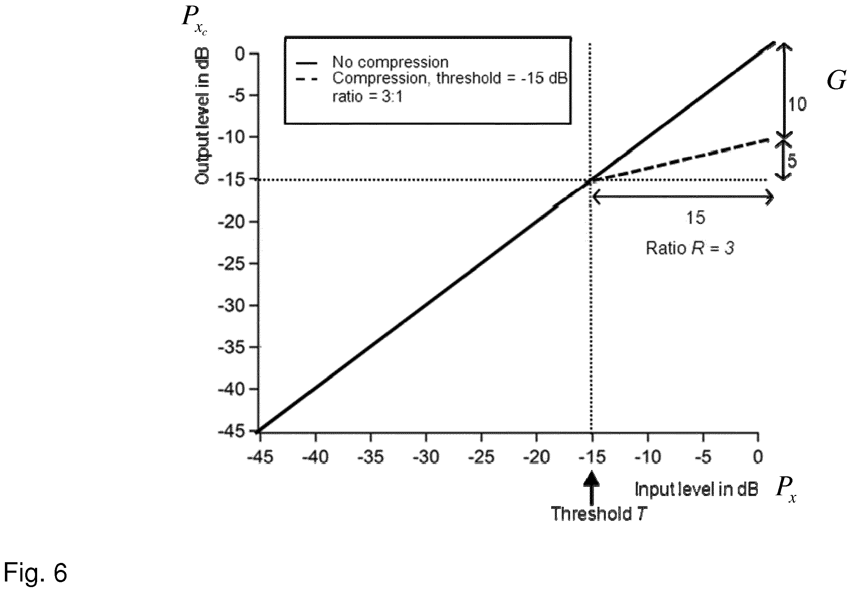

Fig. 6 shows a diagram of a dynamic range compression principle according to an implementation form. The basic principle of dynamic range compression using a static compression curve based on peak amplitude detection is illustrated. The case of no compression is illustrated by the solid line. The case of compression using a compression threshold of -15 dB and a compression ratio of 3:1 is illustrated by the dashed line.

The transfer function between the input signal x and the compressed signal $x_c$ can show the following behavior. In case the level of the input signal x is below a given threshold T specified in dB, it may not be modified; the compressed signal $x_c$ can be identical to x. In case the level of the input signal x exceeds the threshold T, $x_c$ can be reduced by a given compression ratio R. The compression ratio can relate level changes of the input signal to level change of the output signal. In this example, a compression ratio of R=3 can indicate that a level exceeding the threshold T by 3 dB in the input signal can be reduced to a level only 1 dB above the threshold in the output signal. As a result, the level $P_{x_c}$ of the compressed signal can be reduced, compared to the level $P_x$ of the input signal, according to the time variant gain g(t).

Eqn. 1 can be given as follows:

$$P_x(t) = 20\log_{10}\left|x(t)\right|$$

$$g(t) = \begin{cases} -(1\text{-}1/R)\cdot(P_x(t)-T) & , P_x(t) > T \\ 0 & , P_x(t) \le T \end{cases}$$

$$P_{x_c}(t) = P_x(t) + g(t)$$

This can be the basic principle of dynamic range compression. As DRC can be an important topic in music recording and production, even in the analogue domain, many different implementation and extensions can be applied. In particular, the piecewise linear compression curve shown in Fig. 6 may be replaced by a soft compression curve, e.g., with a knee, or a saturating compression curve such as a sigmoid.

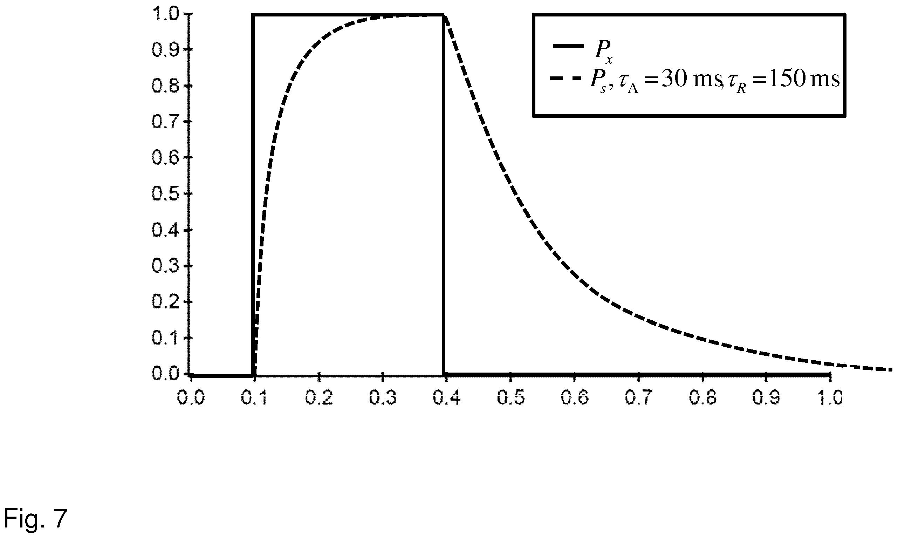

Fig. 7 shows a diagram of temporal smoothing using exponential decays according to an implementation form. The temporal smoothing using exponential decays can be employed for modeling attack and/or decay times. The solid line illustrates $P_x$. The dashed line illustrates $P_s$ using an attack filtering time constant of 30 ms and a release filtering time constant of 150 ms.

Without temporal smoothing, the dynamic range compression can introduce many artifacts because the level of the output signal can change too quickly. The output signal may not resemble the characteristics of the input signal. In order to reduce the audible artifacts of the DRC, the compression gain can be changing slowly.

An approach to achieve this effect can be to smooth the detection of the peak amplitude by adding exponential decays for attack and release times as illustrated in Fig. 7. Specifying different time constants $\tau_A$, $\tau_R$ for attack, index A, and release, index R, can allow for controlling the smoothing effect on different states of an acoustic event. Attack can refer to the start of an event going along with an increase in signal level. Release can refer to the energy decay of this event which is typically slower. The exponential decays for attack and release can be computed as follows:

$\tau_A$, $\tau_R$ can be defined as times to reach 63% of a final value for attack and release;
$\alpha_R = e^{-1/\tau_R}$ and $\alpha_A = e^{-1/\tau_A}$.

Eqn. 2 can be given as follows:

$$P_s(t) = \begin{cases} \alpha_A P_s(t-1) + (1-\alpha_A)P_x(t) & , \quad P_x(t) > P_s(t-1) \\ \alpha_R P_s(t-1) & , \quad P_x(t) \le P_s(t-1) \end{cases}$$

Then, $P_s(t)$ can be used in Eqn. 1 or 2 for the computation of the time-variant gain g(t) replacing $P_x(t)$.

Different implementations can be used, e.g., decoupled, branching, feed-forward, feedback, side-chain, biased, and/or post gain implementations.

The temporal smoothing parameter settings can be relevant and can constitute a trade-off between the amount of compression and the audio quality, i.e. artifacts. In particular, they can affect how amplitude peaks as resulting from drums or transients can be affected. In case of a long release time constant, after a peak or transient, the signal can be attenuated for a long time, and $P_y$ can be reduced too much. In case of a short release time constant, a jump in signal level after a transient can occur. In case of a long attack time constant, transients may not be attenuated as they may be shorter than the attack time, and the peak level can still be high. In case of a short attack time constant, transients can be squashed resulting in a lack of clarity, the level can be reduced too much, and the level of the transients can be the same as the level of the signal right before the transient.

Different solutions can be applied for DRC. The four main criteria to rate DRC algorithms can be sound quality, compression rate, computational complexity, and user controllability. There can be a trade-off between compression and quality as high compression can typically result in poor sound quality. Peaks in the waveform, e.g. transients or attacks, can be attenuated to obtain a high compression gain. This can result in a lack of perceptual clarity. High quality dynamic range compression systems as used for example in TV and radio broadcasting can typically work in frequency domain or on a sub-band decomposition of the full-band signal. This can result in a high computational complexity. In particular for mobile devices, computational and energy resources can be limited.

Parameter settings can be relevant for obtaining a high amount of compression while retaining a high audio quality. Optimal parameter settings can also depend on the specific audio signal and the listening environment. For applications in consumer devices, parameters can typically be predefined using a conservative or less optimal setting. The user may not have any control mechanism except for on or off.

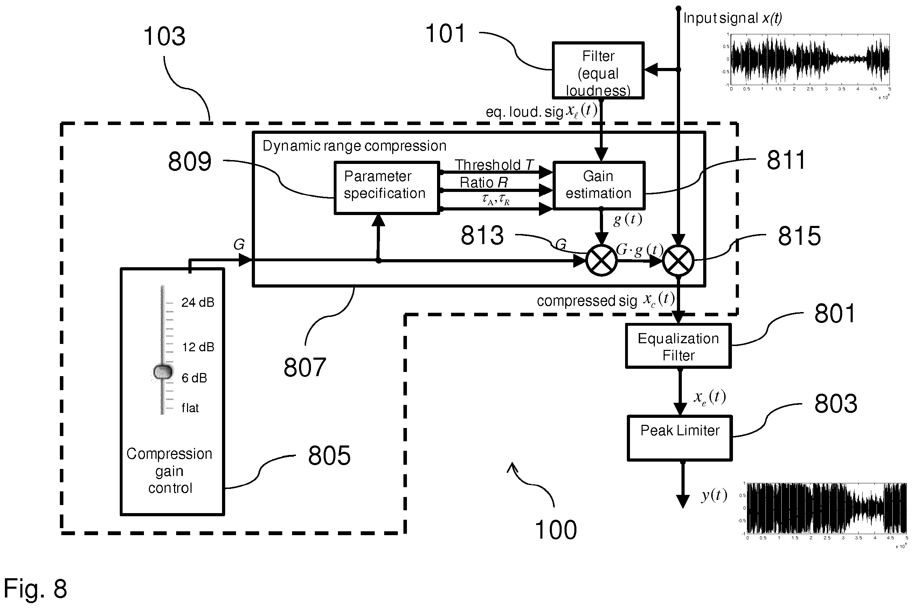

Fig. 8 shows a diagram of an audio compression system 100 for compressing an input audio signal according to an implementation form. The audio compression system 100 can comprise a dynamic range compression system.

The audio compression system 100 comprises a digital filter 101, a compressor 103, an equalization filter 801, and a peak limiter 803. The compressor 103 comprises a compression gain control 805, and a compression unit 807. The compression unit 807 comprises a parameter specification unit 809, a gain estimation unit 811, a first multiplier 813, and a second multiplier 815. The parameter specification unit 809 provides a compression threshold, a compression ratio, an attack filtering time constant, and a release filtering time constant to the gain estimation unit 811.

Many approaches focus on music production applications. The invention particularly addresses mobile sound reproduction scenarios where the goal can be to increase the average output level produced by the speakers of the mobile device such as a smartphone and/or a tablet in real-time while retaining a high sound quality and low computational complexity and low power consumption or low battery power consumption.

An implementation can relate to an enhanced audio compression system 100 or dynamic range compression system as depicted in Fig. 8. The audio compression system 100 can comprise a model of human sound perception to consider the frequency characteristic of the sensitivity of the human ear, i.e. a digital filter 101 or filter equal loudness module. The audio compression system 100 can comprise a cascaded dynamic range compression system to reduce the level of transients while retaining signal clarity, i.e. a compressor 103 or dynamic range compression module cascaded with a peak limiter 803 or peak limiter module. The audio compression system 100 or system can comprise a single control parameter for the compression gain G which can be controlled by the user or consumer in a continuous fashion. The audio compression system 100 or system can comprise a low-complexity full-band implementation in time-domain for real-time applications on mobile devices.

An audio compression system 100 or system is depicted in Fig. 8. Given an input signal x(t), the audio compression system 100 or system can execute the following steps.

In accordance with the invention, firstly, a digital filter 101 or filter equal loudness module is applied, i.e. a preprocessing operation applying a simplified loudness model by filtering the input signal x(t) with an equal loudness curve in order to obtain a loudness equalized input signal $x_l(t)$. The goal of the preprocessing is to emphasize frequencies in the signal where the human ear is less sensitive. Secondly, a compressor 103 or dynamic range compression module is applied. It can comprise a parameter specification unit 809 or parameter specification module. Given an externally, e.g. user specified desired compression gain in dB, the internal dynamic range compression parameters $T, R, \tau_A, \tau_R$ can be adjusted in an optimal manner. It further comprises a gain estimation unit 811 or gain estimation module which estimates the time variant gain g(t) from the loudness equalized input signal $x_l(t)$. The obtained compression is stronger in regions which have been emphasized by the equalization which correspond to regions where the human ear is less sensitive. As a result, artifacts of the dynamic range compression can be less audible and a stronger compression can be applied. The dynamic range compression of the input signal x(t) can be performed by applying the time variant gain g(t) and the desired compression gain G to the signal x(t) to obtain the compressed signal $x_c(t)$. Thirdly, an equalization filter 801 or equalization module can optionally be applied which can apply an equalization to $x_c(t)$ to correct for the frequency dependent compression and recreate a flat frequency response of the signal $x_e(t)$. This can also take the frequency response of the loudspeakers into account. Fourthly, a peak limiter 803 can optionally be applied. A soft limiting of the peaks and/or transients can be applied to prevent clipping in strong attack phases to obtain the output signal y(t).

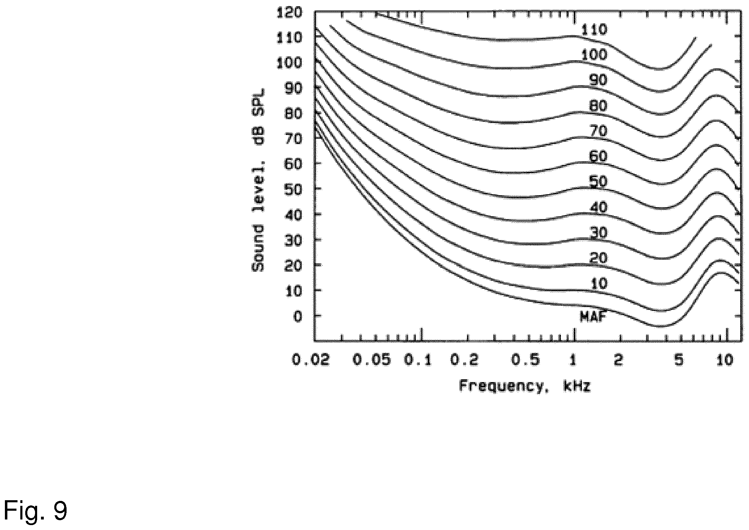

Fig. 9 shows a diagram of different equal loudness curves according to an implementation form.

The ear is not be equally sensitive to all frequencies. Fig. 9 shows the response to different frequencies over the entire audible range as a set of curves showing the sound pressure levels perceived as being equally loud. For low and high frequencies, the sound pressure level can be much higher to obtain the same perceived loudness as in mid frequencies. The curves are lowest in the range from 2 to 5 kHz, with a dip at 4 kHz, indicating that the ear is most sensitive to frequencies in this range. The intensity level of higher or lower tones can be raised substantially in order to create the same impression of loudness. This finding can be exploited to achieve a higher sound quality of the output signals. The idea is to apply stronger dynamic range compression in those frequency regions where the human ear is less sensitive.

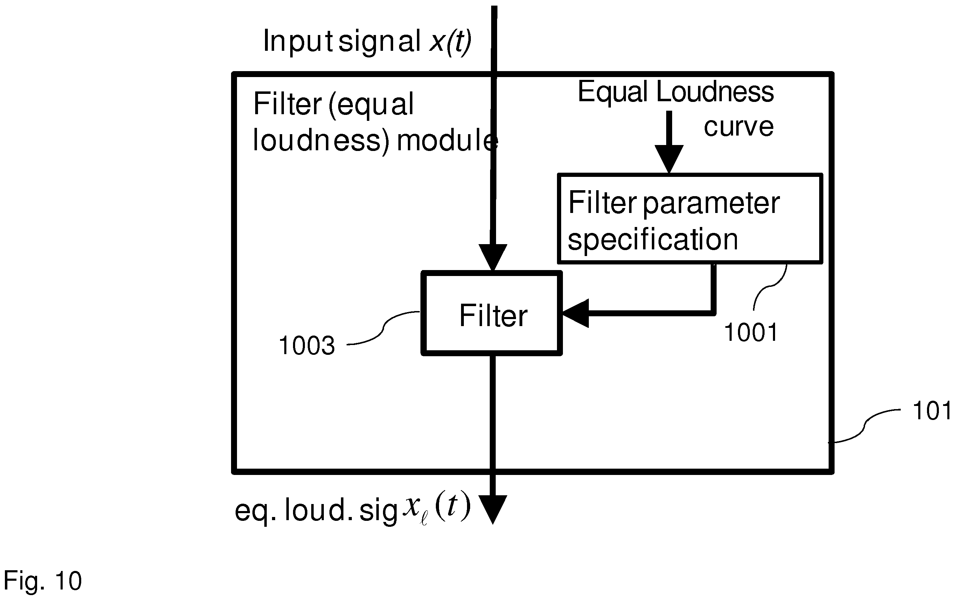

Fig. 10 shows a diagram of a digital filter 101 for filtering an audio signal according to an implementation form. The digital filter 101 can comprise a filter equal loudness module.

The digital filter 101 can comprise a determining unit 1001 and a filtering unit 1003. The determining unit 1001 can be used for filter parameter specification, wherein an equal loudness curve can be provided to the determining unit 1001 to obtain filter coefficients. The filtering unit 1003 can filter an input signal x(t) upon the basis of the filter coefficients to obtain a loudness equalized signal $x_l(t)$.

A loudness model can be applied to model the sensitivity of the human ear by filtering with an equal loudness curve. This can enhance frequencies where the human ear is less sensitive and can attenuate frequencies where the human ear is highly sensitive.

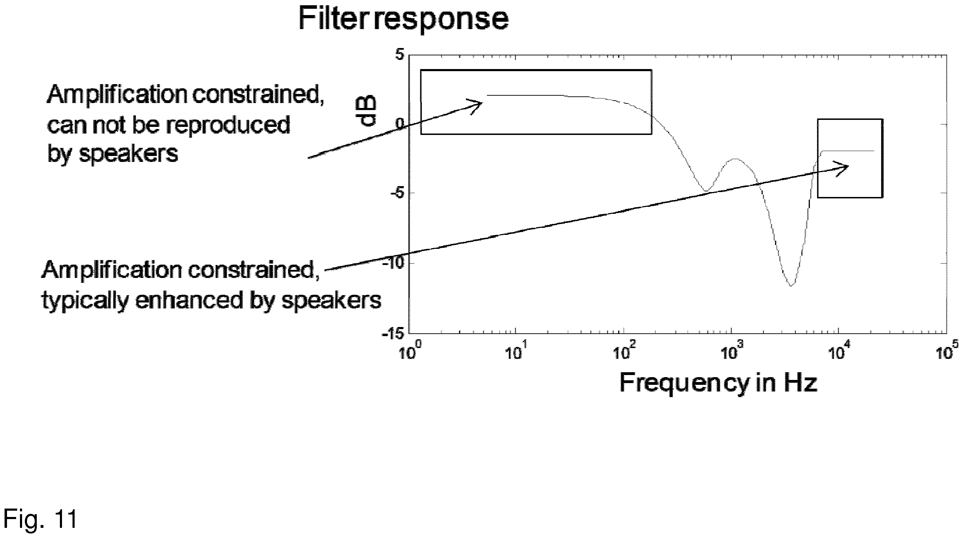

Fig. 11 shows a diagram of a frequency response of a digital filter used to model the loudness sensitivity of the human ear according to an implementation form. At low frequencies, the amplification can be constrained and may not be reproduced by speakers. At high frequencies, the amplification can be constrained and is typically enhanced by speakers.

The following processing can be used to obtain this effect, see Fig. 10. Perform a filtering with a filter response which resembles the equal loudness curve. This can enhance the level at frequencies where the human ear is less sensitive and can attenuate frequencies where the human ear is highly sensitive. Then, the subsequent dynamic range compression can be concentrated in frequency regions where the human ear is less sensitive, i.e. high and low frequencies. As a result, compression artifacts can be less audible. In particular, the frequency range 2-5 kHz or 2-6 kHz can hardly be modified by the dynamic range compression. This range can be most important for sound clarity.

The filter response as shown in Fig. 11 can be based on equal loudness curves but modified according to several aspects. To consider micro-speaker characteristics and capabilities, the amplification of lowest and highest frequencies can be limited by introducing an upper limit. The motivation for this limit can be based on the considered application scenario using small speakers. Here, lowest frequencies may not be reproduced by the speakers and high frequencies can typically be amplified by such speakers. Limiting the amplifications can take this into account. The overall range, i.e. difference between minimum and maximum of the filter response, of the amplification can be restricted to just span 15 dB. From Fig. 9 it can be seen that the differences between minimum and maximum values in sound pressure levels of a single equal loudness curve can reach up to 80 dB. In the dynamic range compression, the threshold T can, in typical applications scenarios, be set to values between 6 and 20 dB. As a result, applying a equalization which can amplify certain frequencies by 80 dB compared to others can result in only these frequencies being highly compressed, other, however, may not reach the threshold and may therefore be not compressed at all. Constraining the overall range of amplification can allow to control the strength of the dynamic range compression in different frequency regions.

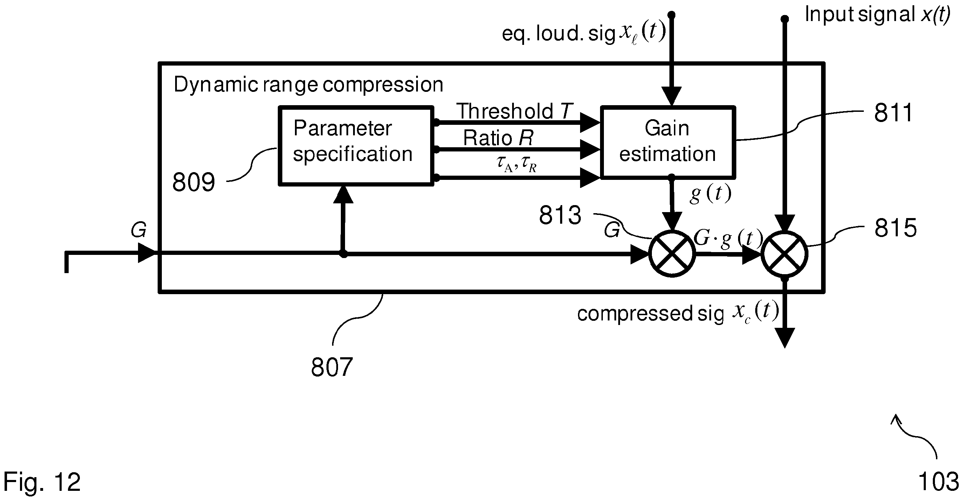

Fig. 12 shows a diagram of a compressor 103 for compressing an input audio signal according to an implementation form. The compressor 103 can comprise a compression unit 807 or dynamic range compression module.

The compression unit 807 comprises a parameter specification unit 809, a gain estimation unit 811, a first multiplier 813, and a second multiplier 815. The parameter specification unit 809 provides a compression threshold T, a compression ratio R, and an attack filtering time constant and a release filtering time constant $\tau_R, \tau_A$ to the gain estimation unit 811. A loudness equalized audio signal $x_l(t)$ can be provided to the gain estimation unit 811. An input audio signal x(t) can be provided to the second multiplier 815. A compressed audio signal $x_c(t)$ can be provided by the second multiplier 815.

Subsequently, the dynamic range compression can be applied to the input signal as shown in Fig. 12. The dynamic range compression can follow the general description and can use the same notation.

First, given a desired compression gain G, e.g. specified by the user, parameters $T, R, \tau_A, \tau_R$ for the dynamic range compression as introduced can be derived as follows. The goal can be to compress the signal such that a headroom of G is created between the peak amplitude of $x_c(t)$ and the maximum value $P_{max}$ which can be reproduced without clipping.

$$\max(P_{x_c}(t)) \overset{!}{=} P_{max} - G$$

$$T = P_{max} - G \cdot \lambda(1 + 1/R)$$

The finding can be that for obtaining the desired gain G, different values for R and T are possible. Lowering the threshold can allow obtaining a higher G, but at the same time can also increase the amount of signal components to be affected by the DRC. Increasing the compression ratio R, the components above the threshold can be stronger compressed. Selecting R and T values which are optimal in terms of perceptual quality can be a difficult task. A finding is that a certain relation between the threshold T and the compression ratio R is desirable to obtain high quality. Furthermore, extensive listening tests revealed that the perceptual quality of the dynamic range compression is optimal when it is approximately

$$R \approx G / (2dB) .$$

The temporal smoothing constants $\tau_A$, $\tau_R$ can affect the DRC result by reducing the amount of compression to ensure temporal continuity which can be important for obtaining a high perceptual quality. As a result, the final compression which is achieved is lower than the desired G. The stronger the smoothing, i.e. large time constants $\tau_A$, $\tau_R$, the lower the achieved compression. For obtaining the best possible perceptual quality, the parameter values for the time constants can be chosen depending on the desired compression gain G.

$$\tau_A \approx -0.0002 \text{sec/dB} \cdot G + 0.006 \text{sec}$$

$$\tau_R \approx -0.0033 \text{sec/dB} \cdot G + 0.12 \text{sec}$$

Perceptual listening tests revealed that a linear dependency between the time constants and G lead to the best results. For increasing values of G the time constants can be linearly decreased.

As a result of the smoothing, it may happen that $P_s < P_x$. Therefore, an addition of a tolerance $\lambda \geq 1$ can be desirable to guarantee that the desired compression gain G can be achieved. The tolerance can take into account that fast transients may be missed by the attack decay and can result in high signal peaks. Therefore, the value of the tolerance can be chosen according to the attack time constant.

$$\lambda = 1.122 + 65 \cdot 1/\sec \cdot \tau_A$$

After deriving an optimal parameter setting, the time variant gain g(t) can be estimated from the loudness equalized signal $x_l(t)$.

$$g(t) = \begin{cases} -(1-1/R) \cdot (P_s(t) - T) & , P_s(t) > T \\ 0 & , P_s(t) \leq T \end{cases}$$

*where*

$$P_s(t) = \begin{cases} \alpha_A P_s(t-1) + (1 - \alpha_A) P_x(t) & , \quad P_x(t) > P_s(t-1) \\ \alpha_R P_s(t-1) & , \quad P_x(t) \leq P_s(t-1) \end{cases}$$

*and*

$$\alpha_R = e^{-1/\tau_R}, \alpha_A = e^{-1/\tau_A}$$

Finally, the gain can be multiplied or amplified by the desired compression gain G and finally multiplied to the original input signal x(t), and not to the loudness equalized signal. This provides best possible quality as the original signal is not be altered by the loudness model but only by the loudness-corrected gain.

$$x_c(t) = x(t) \cdot 10^{G/20} \cdot g(t)$$

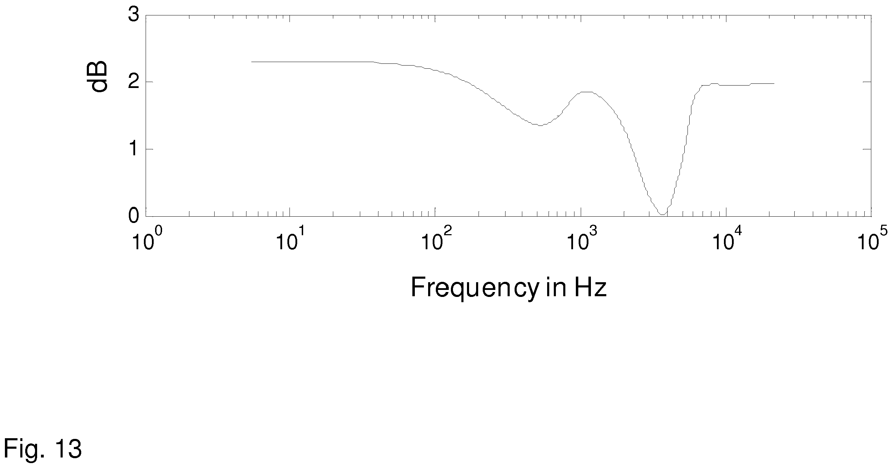

Fig. 13 shows a diagram of a frequency response of an equalization filter, e.g. equalization filter 801, according to an implementation form.

As optional post processing step, an equalization filter 801 can be applied to the signal. Equalization can be desired to compensate for the frequency dependent dynamic range compression. Frequency ranges which are enhanced by the loudness model can be compressed stronger and can therefore receive a lower level than frequencies which are attenuated by the loudness model. While this approach can ensure that dynamic range compression can be concentrated in frequency ranges where the human ear is less sensitive to compression artifacts, it can also result in the output signal not having a flat frequency response. To compensate for this effect, again filtering with a variant of an equal loudness curve can be used.

The filter response as shown in Fig. 13 can be adjusted to compensate for the non-linear compression resulting from the preprocessing filter for equal loudness influencing the computation of the gain g(t). Because the gain g(t) is derived from the loudness equalized signal but can be applied to the original input signal, the compressed signal typically may not have a flat frequency response. In particular, low and high frequencies can be attenuated.

The filter response shown in Fig. 13 can be designed for compensating this effect in the case of an exemplary compression using a threshold T=12 dB and a ratio of 2:1 resulting in a compression gain G of 6 dB. In this case, low and high frequencies can be amplified by roughly 2 dB in order to achieve a flat frequency response. For different values of G the response can be linearly scaled.

The equalization can be desirable to compensate for the frequency dependent dynamic range compression. A filtering with a variant of an equal loudness curve can be used. Potentially, the equalization depends on the compression gain. Also, the target output device may be considered to define the equalization.

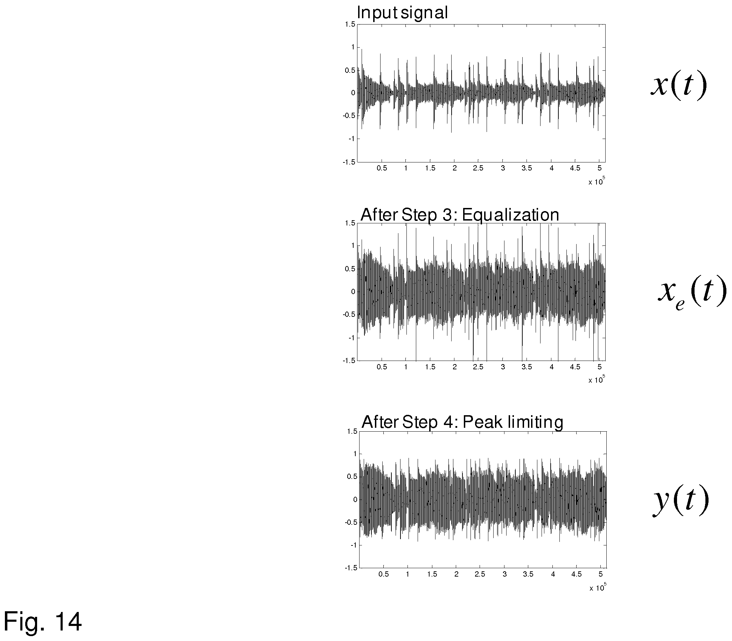

Fig. 14 shows a diagram illustrating an effect of the audio compression system, e.g. audio compression system 100, on an input audio signal x(t) according to an implementation form. The audio compression system can comprise a dynamic range compression system. The first waveform shows an input signal x(t), the second waveform shows an audio signal $x_e(t)$ after step three, i.e. equalization, and the third waveform shows an audio signal y(t) after step four, i.e. peak limiting.

As final step, a peak limiter can be applied to prevent clipping in the output signal. Clipping can refer to the amplitude of the signal exceeding the maximum possible value $P_{max}$. Because of the temporal smoothing performed with the time constants $\tau_R, \tau_A$, fast and strong transients, e.g. drum hits, may not be compressed. As a result, quick changes in signal level can be preserved in the output signal which can be an important aspect to ensure a high perceptual quality or signal clarity. However, these peaks can also prevent that the desired compression gain G can be achieved without clipping. One straight forward solution to this issue can be to decrease the time constants used in the dynamic range compression module. But this can reduce the quality.

A high sound quality can be achieved while avoiding clipping when adding a peak limiter as a final processing step. The peak limiter can be a dynamic range compressor which can be tuned to just affect the remaining peaks of the signal. To this end, the threshold T can be set to a high threshold, e.g. T = -1 dB, and the compression ratio can also be high, e.g. R = 60:1. Together with small values for the attack and release time constants, these settings can assure that any peak exceeding the threshold, thus leading to clipping, can be compressed by a very large ratio, e.g. R = 60:1. As a result, peaks exceeding the threshold can strongly be compressed or soft-clipped to ensure that they do not exceed this threshold.

The slow dynamic range compression performed by the compression unit or dynamic range compression module can ensure that slowly evolving long- and mid-term characteristics of the audio signal can be retained by the compression and the fast reacting peak limiter can perform soft-clipping to only prevent clipping. In combination, signal quality, in particular signal clarity, can be retained as much as possible while still ensuring a high compression gain.

Fig. 14 compares an input signal x(t) with a compressed signal after an equalization $x_e(t)$ as well as the final output signal after the peak limiting y(t). After the dynamic range compression, mid-term level characteristics of the signal can be retained but peaks exceeding amplitude values of [-1;+1] can remain in the signal $x_e(t)$. These can finally be soft-clipped by the peak limiter to obtain the signal y(t).

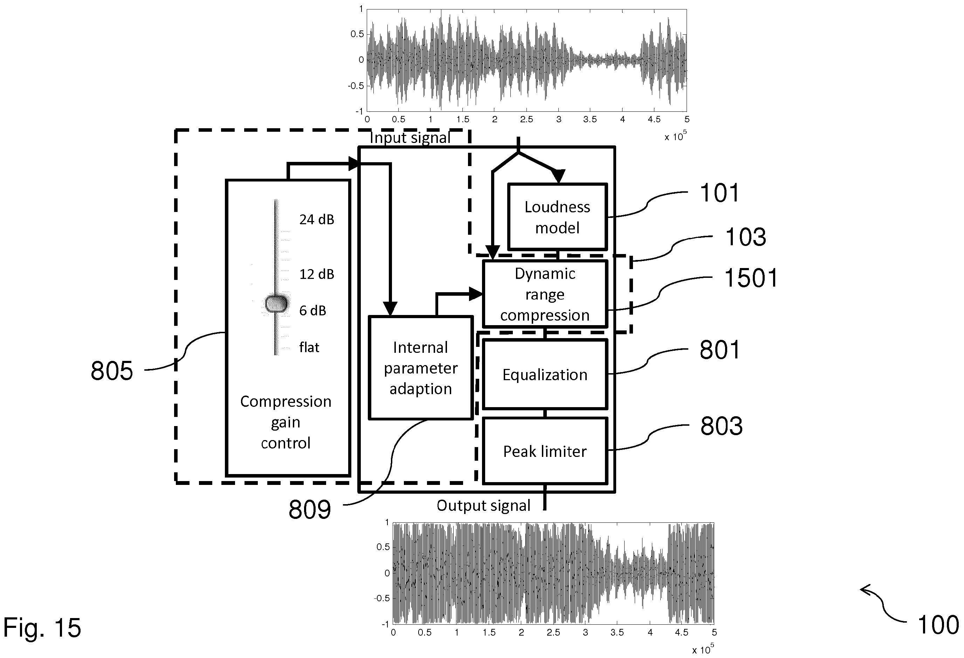

Fig. 15 shows a diagram of an audio compression system 100 for compressing an input audio signal according to an implementation form. The audio compression system 100 can comprise a dynamic range compression system.

The audio compression system 100 comprises a digital filter 101 using a loudness model, a compressor 103, an equalization filter 801, and a peak limiter 803. The compressor 103 comprises a compression gain control 805, a parameter specification unit 809 for internal parameter adaption, and a reduced compression unit 1501 for dynamic range compression. An input audio signal can be provided to the digital filter 101 and to the reduced compression unit 1501. An output signal can be provided by the peak limiter 803.

Applying a simplified loudness model, i.e. a digital filter 101 or a filter with an equal loudness curve, can emphasize frequencies where the human ear is less sensitive. A dynamic range compression can be achieved. Because of the loudness model, the compression can be stronger in regions where the ear is less sensitive and compression artifacts can be less audible. Applying an equalization to correct for the frequency dependent compression and to recreate a flat frequency response can be desirable. A peak limiter 803 to prevent clipping in strong attack phases can be employed.

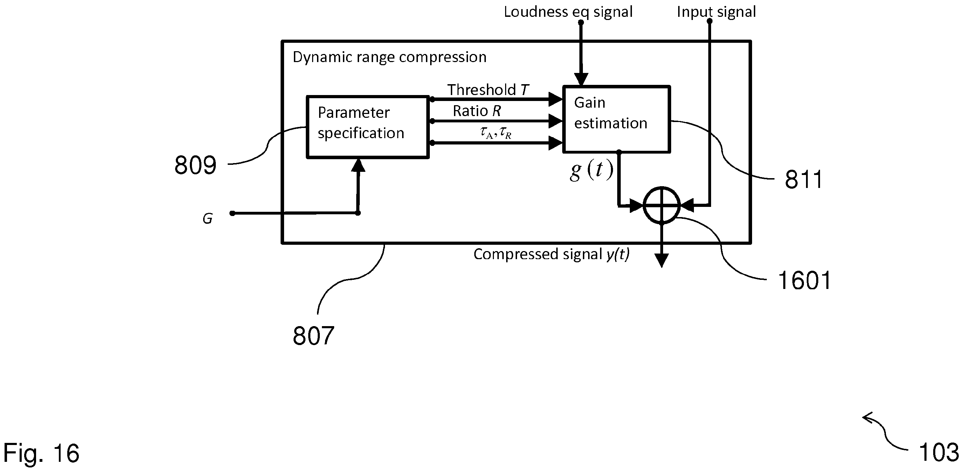

Fig. 16 shows a diagram of a compressor 103 for compressing an input audio signal according to an implementation form. The compressor 103 can comprise a compression unit 807 or dynamic range compression module.

The compression unit 807 comprises a parameter specification unit 809, a gain estimation unit 811, and a combiner unit 1601. The parameter specification unit 809 provides a compression threshold, a compression ratio, an attack filtering time constant, and a release filtering time constant to the gain estimation unit 811. A loudness equalized audio signal can be provided to the gain estimation unit 811. An input audio signal can be provided to the combiner unit 1601. A compressed audio signal can be provided by the combiner unit 1601. A dynamic range compression can be achieved. A gain can be estimated from the loudness equalized signal and applied to the original input signal. Simplifying parameter settings of the dynamic range compression can be desirable. The user can specify a desired compression gain G in a continuous fashion. Parameters for the dynamic range compression $T, R, \tau_A, \tau_R$ can be derived and can be provided to the DRC algorithm. Because it may be that $P_s < P_l$, a tolerance $\lambda \geq 1$ can be added to obtain the desired compression gain G.

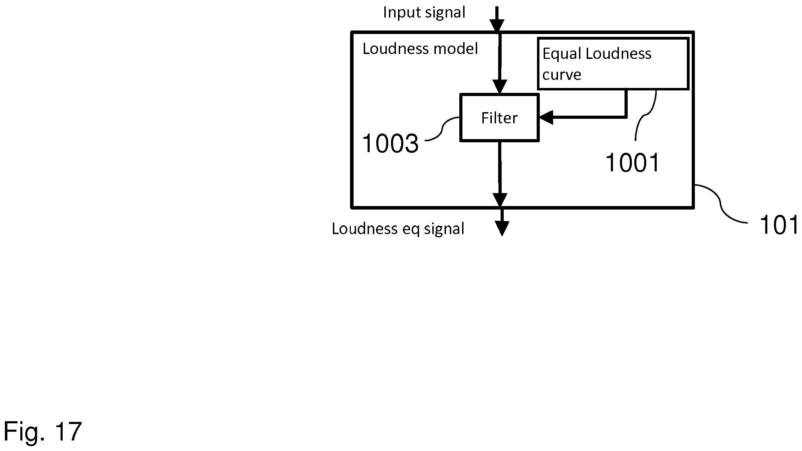

Fig. 17 shows a diagram of a digital filter 101 for filtering an audio signal according to an implementation form. The digital filter 101 can comprise a filter equal loudness module.

The digital filter 101 can comprise a determining unit 1001 using an equal loudness curve, and a filtering unit 1003. The filtering unit 1003 can filter an input audio signal to provide a loudness equalized audio signal. The digital filter 101 can be based on a loudness model. The invention can be specifically tailored for applications on mobile devices with limited electro-acoustic systems, processing capabilities and power consumption. A higher sound quality can be provided. Compression artifacts can be concentrated in frequency ranges with less sensitivity of the human ear. A combination of slow compression and fast peak limiting can preserve the original properties of both, slow and fast components of the signal as much as possible. A perceptual clarity can be preserved. A user controllable strength of the compression can be provided. A single compression gain parameter to specify desired compression gain can be employed. It can be continuously adjustable to adapt to the signal content and/or the listening environment. A computational simple implementation can be provided. A full-band processing instead of a frequency domain and/or sub-band processing can be employed. A low delay can be achieved as no frequency transform and/or sub-band decomposition may be employed.

An implementation relates to a method and apparatus for enhanced dynamic range compression of audio signals comprising a full-band model of human sound perception to consider the frequency characteristic of the sensitivity of the human ear, and a cascaded dynamic range compression and soft-clipping system to reduce the level of transients while retaining signal clarity.

An implementation form relates to the method and apparatus, further comprising a unit to let the user control a single control parameter for the compression gain in a continuous fashion, and an internal converter to derive optimal parameter settings from the specified compression gain parameter.

An implementation relates to a terminal and/or decoder feature.

**Claims**

1. An audio compression system (100) for compressing an input audio signal, the audio compression system (100) comprising:

   a digital filter (101) for filtering the input audio signal, the digital filter (101) comprising a frequency transfer function having a magnitude over frequency configured to emphasize frequencies in the input audio signal where a human ear is less sensitive, the magnitude being formed by an equal loudness curve of the human ear, to obtain a filtered audio signal; and
   a compressor (103) being configured to compress the input audio signal upon the basis of the filtered audio signal to obtain a compressed audio signal, wherein the compressor is configured to compress the input audio signal more at frequencies which have been emphasized by the digital filter (101),
wherein the frequency transfer function is determined by filter coefficients, wherein the digital filter (101) comprises a determining unit (1001) and a filtering unit (1003), wherein the determining unit (1001) is configured to determine the filter coefficients upon the basis of at least one equal loudness curve, and wherein the filtering unit (1003) is configured to filter the audio signal upon the basis of the determined filter coefficients.

2. The audio compression system (100) of claim 1, wherein the digital filter (101) is a time domain filter for time domain filtering a time domain input audio signal to provide a filtered audio signal in time domain.

3. The audio compression system (100) of any of the preceding claims, wherein the frequency transfer function has a constant magnitude below or above a predetermined frequency.

4. The audio compression system (100) of any of the preceding claims, wherein a phase of the frequency transfer function increases or decreases linearly over frequency.

5. The audio compression system (100) of claim 1 to 3, wherein a phase of the frequency transfer function is constant, in particular equal to zero, over frequency.

6. The audio compression system (100) of claim 1, wherein the determining unit (1001) is configured to select filter coefficients associated with the equal loudness curve from a set of filter coefficients associated with different equal loudness curves in order to determine the filter coefficients.

7. The audio compression system (100) of claim 6, wherein the different equal loudness curves are associated with different loudness levels of the audio signal, wherein the determining unit (1001) is further configured to determine the loudness level of the audio signal, and wherein the determining unit (1001) is further configured to select the filter coefficients associated with the equal loudness curve upon the basis of the determined loudness level.

8. The audio compression system (100) of any of the preceding claims, wherein the compressor (103) is configured to determine a compression gain signal upon the basis of the filtered audio signal, and to combine the input audio signal with the compression gain signal to obtain the compressed audio signal.

9. The audio compression system (100) of any of the preceding claims, further comprising an equalization filter (801) for filtering the compressed audio signal, the equalization filter (801) comprising a frequency transfer function having a magnitude over frequency, the magnitude being formed by an equal loudness curve of a human ear.

10. The audio compression system (100) of any of the preceding claims, further comprising a peak limiter (803) for reducing a maximum magnitude of the compressed audio signal in time domain.

11. An audio compression method (200) for compressing an input audio signal, the audio compression method (200) comprising:

   filtering (201) the input audio signal by a digital filter (101), the digital filter (101) comprising a frequency transfer function having a magnitude over frequency configured to emphasize frequencies in the input audio signal where a human ear is less sensitive, the magnitude being formed by an equal loudness curve of the human ear, to obtain a filtered audio signal; and
   compressing (203) the input audio signal upon the basis of the filtered audio signal to obtain a compressed audio signal, wherein the input audio signal is compressed more at frequencies which have been emphasized by the digital filter (101),
   wherein the frequency transfer function is determined by filter coefficients, and the filtering (201) comprises determining the filter coefficients upon the basis of at least one equal loudness curve, and filtering the audio signal upon the basis of the determined filter coefficients.

12. A computer program comprising a program code which, when the program is executed by a computer, causes the computer to perform the audio compression method (200) according to claim 11.

**Patentansprüche**

1. Audiokompressionssystem (100) zum Komprimieren eines Eingangsaudiosignals, wobei das Audiokompressionssystem (100) umfasst:

   ein Digitalfilter (101) zum Filtern des Eingangsaudiosignals, wobei das Digitalfilter (101) eine Frequenztransferfunktion mit einer Größe über der Frequenz umfasst, die konfiguriert ist, Frequenzen in dem Eingangsaudiosignal hervorzuheben, für die ein menschliches Ohr weniger empfindlich ist, wobei die Größe durch eine Kurve gleicher Lautstärke des menschlichen Ohrs gebildet wird, um ein gefiltertes Audiosignal zu erhalten; und einen Kompressor (103), der konfiguriert ist, das Eingangsaudiosignal auf der Basis des gefilterten Audiosignals zu komprimieren, um ein komprimiertes Audiosignal zu erhalten, wobei der Kompressor konfiguriert ist, das Eingangsaudiosignal mehr bei Frequenzen zu komprimieren, die durch das Digitalfilter (101) hervorgehoben wurden, wobei die Frequenztransferfunktion durch Filterkoeffizienten bestimmt ist, wobei das Digitalfilter (101) eine Bestimmungseinheit (1001) und eine Filterungseinheit (1003) umfasst, wobei die Bestimmungseinheit (1001) konfiguriert ist, die Filterkoeffizienten auf der Basis von mindestens einer Kurve gleicher Lautstärke zu bestimmen, und wobei die Filterungseinheit (1003) konfiguriert ist, das Audiosignal auf der Basis der bestimmten Filterkoeffizienten zu filtern.

2. Audiokompressionssystem (100) nach Anspruch 1, wobei das Digitalfilter (101) ein Zeitbereichsfilter zur Zeitbereichsfilterung eines Zeitbereichs-Eingangsaudiosignals ist, um ein gefiltertes Audiosignal im Zeitbereich bereitzustellen.

3. Audiokompressionssystem (100) nach einem der vorhergehenden Ansprüche, wobei die Frequenztransferfunktion eine konstante Größe unterhalb oder über einer vorbestimmten Frequenz aufweist.

4. Audiokompressionssystem (100) nach einem der vorhergehenden Ansprüche, wobei sich eine Phase der Frequenztransferfunktion linear über die Frequenz erhöht oder verringert.

5. Audiokompressionssystem (100) nach Anspruch 1 bis 3, wobei eine Phase der Frequenztransferfunktion über die Frequenz konstant, insbesondere gleich null, ist.

6. Audiokompressionssystem (100) nach Anspruch 1, wobei die Bestimmungseinheit (1001) konfiguriert ist, Filterkoeffizienten, die mit der Kurve gleicher Lautstärke assoziiert sind, aus einem Satz von Filterkoeffizienten, die mit unterschiedlichen Kurven gleicher Lautstärke assoziiert sind, auszuwählen, um die Filterkoeffizienten zu bestimmen.

7. Audiokompressionssystem (100) nach Anspruch 6, wobei die unterschiedlichen Kurven gleicher Lautstärke mit unterschiedlichen Lautstärkepegeln des Audiosignals assoziiert sind, wobei die Bestimmungseinheit (1001) ferner konfiguriert ist, den Lautstärkepegel des Audiosignals zu bestimmen, und wobei die Bestimmungseinheit (1001) ferner konfiguriert ist, die Filterkoeffizienten, die mit der Kurve gleicher Lautstärke assoziiert sind, auf der Basis des bestimmten Lautstärkepegels auszuwählen.

8. Audiokompressionssystem (100) nach einem der vorhergehenden Ansprüche, wobei der Kompressor (103) konfiguriert ist, ein Kompressionsverstärkungssignal auf der Basis des gefilterten Audiosignals zu bestimmen und das Eingangsaudiosignal mit dem Kompressionsverstärkungssignal zu kombinieren, um das komprimierte Audiosignal zu erhalten.

9. Audiokompressionssystem (100) nach einem der vorhergehenden Ansprüche, ferner umfassend ein Entzerrungsfilter (801) zum Filtern des komprimierten Audiosignals, wobei das Entzerrungsfilter (801) eine Frequenztransferfunktion mit einer Größe über der Frequenz umfasst, wobei die Größe durch eine Kurve gleicher Lautstärke eines menschlichen Ohrs gebildet wird.

10. Audiokompressionssystem (100) nach einem der vorhergehenden Ansprüche, ferner umfassend einen Spitzenbegrenzer (803) zum Reduzieren einer maximalen Größe des komprimierten Audiosignals im Zeitbereich.

11. Audiokompressionsverfahren (200) zum Komprimieren eines Eingangsaudiosignals, wobei das Audiokompressionsverfahren (200) umfasst:

   Filtern (201) des Eingangsaudiosignals durch ein Digitalfilter (101), wobei das Digitalfilter (101) eine Frequenztransferfunktion mit einer Größe über der Frequenz umfasst, die konfiguriert ist, Frequenzen in dem Eingangsaudiosignal hervorzuheben, für die ein menschliches Ohr weniger empfindlich ist, wobei die Größe durch eine Kurve gleicher Lautstärke des menschlichen Ohrs gebildet wird, um ein gefiltertes Audiosignal zu erhalten; und Komprimieren (203) des Eingangsaudiosignals auf der Basis des gefilterten Audiosignals, um ein komprimiertes Audiosignal zu erhalten, wobei das Eingangsaudiosignal mehr bei Frequenzen komprimiert wird, die durch das Digitalfilter (101) hervorgehoben wurden,

wobei die Frequenztransferfunktion durch Filterkoeffizienten bestimmt wird und das Filtern (201) Bestimmen der Filterkoeffizienten auf der Basis von mindestens einer Kurve gleicher Lautstärke und Filtern des Audiosignals auf der Basis der bestimmten Filterkoeffizienten umfasst.

**12.** Computerprogramm, umfassend einen Programmcode, der, wenn das Programm durch einen Computer ausgeführt wird, den Computer veranlasst, das Audiokompressionsverfahren (200) nach Anspruch 11 durchzuführen.

**Revendications**

**1.** Système de compression audio (100) pour compresser un signal audio d'entrée, le système de compression audio (100) comprenant :

un filtre numérique (101) pour filtrer le signal audio d'entrée, le filtre numérique (101) comprenant une fonction de transfert de fréquence ayant une amplitude par rapport à la fréquence configurée pour accentuer des fréquences dans le signal audio d'entrée là où l'oreille humaine est moins sensible, l'amplitude étant formée par une courbe d'intensité sonore égale de l'oreille humaine, pour obtenir un signal audio filtré ; et
un compresseur (103) étant configuré pour compresser le signal audio d'entrée sur la base du signal audio filtré afin d'obtenir un signal audio compressé, le compresseur étant configuré pour compresser le signal audio d'entrée davantage à des fréquences qui ont été accentuées par le filtre numérique (101),
dans lequel la fonction de transfert de fréquence est déterminée par des coefficients de filtre, dans lequel le filtre numérique (101) comprend une unité de détermination (1001) et une unité de filtrage (1003), dans lequel l'unité de détermination (1001) est configurée pour déterminer les coefficients de filtre sur la base d'au moins une courbe d'intensité sonore égale, et dans lequel l'unité de filtrage (1003) est configurée pour filtrer le signal audio sur la base des coefficients de filtre déterminés.

**2.** Système de compression audio (100) selon la revendication 1, dans lequel le filtre numérique (101) est un filtre de domaine temporel pour réaliser le filtrage de domaine temporel d'un signal audio d'entrée de domaine temporel afin de fournir un signal audio filtré dans le domaine temporel.

**3.** Système de compression audio (100) selon l'une quelconque des revendications précédentes, dans lequel la fonction de transfert de fréquence a une amplitude constante inférieure ou supérieure à une fréquence prédéfinie.

**4.** Système de compression audio (100) selon l'une quelconque des revendications précédentes, dans lequel une phase de la fonction de transfert de fréquence augmente ou diminue linéairement en fonction de la fréquence.

**5.** Système de compression audio (100) selon les revendications 1 à 3, dans lequel une phase de la fonction de transfert de fréquence est constante, en particulier égale à zéro, en fonction de la fréquence.

**6.** Système de compression audio (100) selon la revendication 1, dans lequel l'unité de détermination (1001) est configurée pour sélectionner des coefficients de filtre associés à la courbe d'intensité sonore égale à partir d'un ensemble de coefficients de filtre associés à différentes courbes d'intensité sonore égale dans le but de déterminer les coefficients de filtre.

**7.** Système de compression audio (100) selon la revendication 6, dans lequel les courbes d'intensité sonore égale différentes sont associées à différents niveaux d'intensité sonore du signal audio, dans lequel l'unité de détermination (1001) est en outre configurée pour déterminer le niveau d'intensité sonore du signal audio, et dans lequel l'unité de détermination (1001) est en outre configurée pour sélectionner les coefficients de filtre associés à la courbe d'intensité sonore égale sur la base du niveau d'intensité sonore déterminé.

**8.** Système de compression audio (100) selon l'une quelconque des revendications précédentes, dans lequel le compresseur (103) est configuré pour déterminer un signal de gain de compression sur la base du signal audio filtré, et pour combiner le signal audio d'entrée avec le signal de gain de compression afin d'obtenir le signal audio compressé.

9. Système de compression audio (100) selon l'une quelconque des revendications précédentes, comprenant en outre un filtre d'égalisation (801) pour filtrer le signal audio compressé, le filtre d'égalisation (801) comprenant une fonction de transfert de fréquence ayant une amplitude par rapport à la fréquence, l'amplitude étant formée par une courbe d'intensité sonore égale d'une oreille humaine.

10. Système de compression audio (100) selon l'une quelconque des revendications précédentes, comprenant en outre un limiteur de crête (803) pour réduire une amplitude maximum du signal audio compressé dans le domaine temporel.

11. Procédé de compression audio (200) pour compresser un signal audio d'entrée, le procédé de compression audio (200) comprenant :

le filtrage (201) du signal audio d'entrée par un filtre numérique (101), le filtre numérique (101) comprenant une fonction de transfert de fréquence ayant une amplitude par rapport à la fréquence configurée pour accentuer des fréquences dans le signal audio d'entrée là où l'oreille humaine est moins sensible, l'amplitude étant formée par une courbe d'intensité sonore égale de l'oreille humaine, pour obtenir un signal audio filtré ; et
la compression (203) du signal audio d'entrée sur la base du signal audio filtré afin d'obtenir un signal audio compressé, le signal audio d'entrée étant compressé davantage à des fréquences qui ont été accentuées par le filtre numérique (101),
dans lequel la fonction de transfert de fréquence est déterminée par des coefficients de filtre, et le filtrage (201) comprend la détermination des coefficients de filtre sur la base d'au moins une courbe d'intensité sonore égale, et le filtrage du signal audio sur la base des coefficients de filtre déterminés.

12. Programme informatique comprenant un code de programme qui, lorsque le programme est exécuté par un ordinateur, amène l'ordinateur à réaliser le procédé de compression audio (200) selon la revendication 11.

Fig. 1

EP 3 100 353 B1

201

203

200

Fig. 2

101

Fig. 3

Fig. 4

Original signal, peak amplitude = 1.0

Compressed signal, peak amplitude = 1.0

Fig. 5

EP 3 100 353 B1

Fig. 6

Fig. 7

Fig. 8

Fig. 9

EP 3 100 353 B1

Input signal $x(t)$

Filter (equal loudness) module

Equal Loudness curve

Filter parameter specification

Filter

1003

1001

101

eq. loud. sig $x_\ell(t)$

Fig. 10

Fig. 11

Fig. 12

EP 3 100 353 B1

Fig. 13

Input signal

$x(t)$

After Step 3: Equalization

$x_e(t)$

After Step 4: Peak limiting

$y(t)$

Fig. 14

Loudness model — 101

Dynamic range compression — 103, 1501

Equalization — 801

Peak limiter — 803

Internal parameter adaption — 809

Input signal

Output signal

Compression gain control — 805

24 dB
12 dB
6 dB
flat

x 10⁵

100

Fig. 15

Fig. 16

Input signal

Loudness model

Equal Loudness
curve

Filter

1003

1001

101

Loudness eq signal

Fig. 17

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2009116664 A1
- WO 2011141772 A1

- WO 2006047600 A1

**Non-patent literature cited in the description**

- **G. W. MCNALLY.** Dynamic Range Control of Digital Audio Signals. *Journal of the Audio Engineering Society,* 1984, vol. 32, 316-327